# EUROPÄISCHE PATENTSCHRIFT

(11) **EP 0 725 169 B1**
(45) Veröffentlichungstag und Bekanntmachung des Hinweises auf die Patenterteilung: **25.11.1998**
(21) Anmeldenummer: 96101379.4
(22) Anmeldetag: 01.02.1996
(51) Int. Cl.: C30B 15/14

(54) **Vorrichtung zur Herstelllung eines Einkristalls**
Apparatus for manufacturing a single crystal
Dispositif pour la fabrication d'un monocristal

(30) Priorität: 02.02.1995 DE 19503357
(43) Veröffentlichungstag der Anmeldung: 07.08.1996
(73) Patentinhaber: Wacker Siltronic Gesellschaft für Halbleitermaterialien Aktiengesellschaft, 84489 Burghausen (DE)
(72) Erfinder: von Ammon, Wilfried, Dr., D-84489 Burghausen (DE); Dornberger, Erich, D-84489 Burghausen (DE); Weidner, Herbert, D-84533 Haiming (DE); Pardubitzki, Alfred, D-84489 Burghausen (DE)
(74) Vertreter: Rimböck, Karl-Heinz, Dr.

(56) Entgegenhaltungen:
- EP-A- 0 591 525
- DE-A- 3 905 626
- US-A- 3 265 469
- PATENT ABSTRACTS OF JAPAN vol. 10 no. 235 (C-366) [2291] ,14.August 1986 & JP-A-61 068389 (SONY CORP.) 8.April 1986,

## Beschreibung

Gegenstand der Erfindung ist eine Vorrichtung zur Herstellung eines Einkristalls aus Halbleitermaterial nach der Czochralski-Methode. Eine derartige Vorrichtung ist beispielsweise in der Patentschrift US-5,316,742 beschrieben. Sie weist einen Tiegel auf, der mit schmelzflüssigem Halbleitermaterial gefüllt ist. Aus der Schmelze wird nach Eintauchen eines Impfkristalls ein stabförmiger Einkristall gezogen. Der Tiegel ruht auf einer axial heb- und senkbaren Welle, die während des Ziehens des Einkristalls angehoben wird. Durch diese Bewegung wird erreicht, daß die axiale Lage der Oberfläche der Schmelze unverändert bleibt, obwohl sich das Schmelzenvolumen infolge des Kristallwachstums ständig verringert. Ein wichtiges Merkmal einer Vorrichtung der genannten Art ist ein Hitzeschild, der den wachsenden Einkristall vor Wärmestrahlung abschirmt, die hauptsächlich von den Tiegelwänden und einer seitlich um den Tiegel angeordneten Strahlungsheizung abgestrahlt wird. Der koaxial zum Einkristall gehaltene Hitzeschild reicht nahe an die Schmelzenoberfläche heran und bewirkt im Bereich der Kristallisationsfront des Einkristalls einen steilen axialen Temperaturgradienten. Der Temperaturgradient ist gekennzeichnet durch eine stark fallende Temperatur zwischen der Kristallisationsfront und der festen Einkristallphase und wesentlich dafür verantwortlich, daß der Einkristall mit einer hohen Geschwindigkeit gezogen werden kann. Ist zusätzlich zum Hitzeschild eine Kühlvorrichtung vorgesehen, die eine Kühlung des wachsenden Einkristalls bewirkt, lassen sich besonders hohe Ziehgeschwindigkeiten erreichen. Bekannte Kühlvorrichtungen bestehen aus einem Kanalsystem, das den Einkristall umgibt und von einem flüssigen Kühlmittel durchströmt wird. Ausführungsformen, bei denen die Kühlvorrichtung bis nahe an die Oberfläche der Schmelze herangeführt ist, bergen allerdings ein hohes Sicherheitsrisiko. Ein Fehler oder das Versagen der Steuerung des Tiegelhubs kann dazu führen, daß die Kühlvorrichtung teilweise in die Schmelze taucht, zerstört wird, wobei Kühlmittel austritt und in die heiße Schmelze gelangt. Die Auswirkungen eines solchen, nicht auszuschließenden Unfalls lassen sich nur durch umfangreiche und teuere sicherheitstechnische Maßnahmen auf ein vertretbares Maß begrenzen. Durch Ausführungsformen, bei denen die Kühlvorrichtung selbst bei maximalem Tiegelhub nicht in die Schmelze tauchen kann, wird das geschilderte Sicherheitsrisiko zwar vermieden. Doch bleibt der Abstand der Kühlvorrichtung zur Oberfläche der Schmelze vergleichsweise groß und der Einfluß der Kühlung auf den axialen Temperaturgradienten im Bereich der Kristallisationsfront gering.

Weiter beschreibt die US-A-3 265 469 eine Vorrichtung zur Herstellung eines Einkristalls nach der Crochralski-Methode, mit einem, der wachsenden Einkristall abschirmenden Hitzeschild und einer, den wachsenden Einkristall kühlenden Kühlvorrichtung, die als gut wärmeleitender Kühlkörper ausgebildet ist und im oberen Teil ein Kanalsystem umfaßt, durch das ein Kühlmittel strömt.

Die Aufgabe der vorliegenden Erfindung besteht darin, eine Kühlvorrichtung anzugeben, die ein hohes Maß an Sicherheit gewährleistet und dennoch einen steilen axialen Temperaturgradienten im Bereich der Kristallisationsfront des Einkristalls bewirkt.

Die Aufgabe wird erfindungsgemäß mit den Merkmalen der Vorrichtung nach Anspruch 1 gelöst.

Das Kanalsystem besteht beispielsweise aus mindestens einem ringförmigen oder spiralen- oder mäanderförmig gewendelten Kühlrohr, durch das ein flüssiges Kühlmittel strömt. Bevorzugtes Kühlmittel ist Wasser, da es ausgezeichnete Kühleigenschaften besitzt und gut verfügbar ist. Der Kanal des Kanalsystems, der den geringsten Abstand zur Oberfläche der Schmelze aufweist, muß von der Oberfläche der Schmelze mindestens so weit entfernt sein, daß er die Schmelze nicht berührt, wenn der mit der Schmelze gefüllte Tiegel auf die erreichbare Maximalhöhe angehoben ist. Um dennoch die vom Kanalsystem erzeugte Kühlleistung zur Erhöhung des Temperaturgradienten im Bereich der Kristallisationsfront des Einkristalls optimal nutzen zu können, besteht der untere Teil der Kühlvorrichtung aus einem gut wärmeleitenden Kühlkörper. Kanalsystem und Kühlkörper bilden eine koaxial zum Einkristall gehaltene und diesen umgebende, funktionale Einheit, die nahe an die Oberfläche der Schmelze und nahe an die Kristallisationsfront des wachsenden Einkristalls heranreicht. Der Abstand zwischen dem unteren Rand des Kühlkörpers und der Oberfläche der Schmelze beträgt vorzugsweise 10 bis 150 mm, besonders bevorzugt 20 bis 50 mm. Der Abstand liegt im Bereich des Abstandes, den der untere Rand des Hitzeschilds zur Oberfläche der Schmelze aufweist und der 5 bis 100 mm, bevorzugt 10 bis 20 mm beträgt. Vorzugsweise wird der Durchmesser des Kühlkörpers in Schmelzenrichtung kleiner. Der Abstand zwischen dem unteren Rand des Kühlkörpers und der Kristallisationsfront beträgt bevorzugt 25 bis 60 mm.

Der Kühlkörper muß aus einem gut wärmeleitfähigem Material bestehen, wobei dieses Material weder die Schmelze, noch den Einkristall verunreinigen darf. Die spezifische Wärmeleitfähigkeit des Materials sollte mindestens der von Kupfer entsprechen. In der bevorzugten Ausführungsform ist der Kühlkörper aus Silber gefertigt oder zumindest mit Silber beschichtet. Gemäß einer weiteren Ausführungsform ist vorgesehen, daß die zum Einkristall gerichtete Innenseite des Kühlkörpers geschwärzt ist, so daß auftreffende Wärmestrahlung absorbiert wird. Die zum Hitzeschild weisende Außenseite des Kühlkörpers ist vorzugsweise so beschaffen, daß auftreffende Wärmestrahlung reflektiert wird. Dies kann beispielsweise durch Hochglanzpolieren dieser Seite oder durch Beschichten dieser Seite mit einer Goldauflage erreicht werden.

Zwischen dem Kanalsystem und dem Kühlkörper muß eine weitgehend ungehinderte Wärmeleitung gewährleistet sein. Diese Bedingung ist beispielsweise erfüllt, wenn die Kühlvorrichtung aus einem Stück gefertigt ist. Es genügt jedoch, wenn sich Kanalsystem und Kühlkörper flächenhaft berühren und der Kühlkörper am Kanalsystem befestigt ist. Als Befestigungsmittel kommen beispielsweise Schrauben, Nieten, Klammern und gelötete oder geschweißte Verbindungen in Betracht. Besonders bevorzugt ist eine temperaturabhängig lösbare Befestigung, die sich bei einer bestimmten Temperatur, beispielsweise der Siedetemperatur des Kühlmittels, selbstständig löst. Dazu eignet sich zum Beispiel die Befestigung durch ein bei der entsprechenden Temperatur schmelzendes Lot. Sobald der Kühlkörper der Kühlvorrichtung wegen einer Fehlsteuerung des Tiegelhubs in die Schmelze eintaucht, wird das Lot so stark erwärmt, daß es schmilzt. Daraufhin löst sich die Befestigung und der Kühlkörper wird wegen seines Eigengewichts in die Schmelze fallen. Eine weitere, gefährliche Erwärmung des Kanalsystems der Kühlvorrichtung ist danach wegen der unterbrochenen Wärmeleitung nicht mehr möglich. Die sich in Abhängigkeit von der Temperatur automatisch lösende Befestigung der Kühlkörpers ist jedoch nicht zwingend notwendig. Denn auch ohne eine solche Befestigung bleibt im geschilderten Krisenfall genügend Zeit, um Gegenmaßnahmen treffen zu können, bevor der mit dem Kanalsystem ausgestattete Teil der Kühlvorrichtung durch Wärmeleitung auf eine kritische Temperatur aufgeheizt wird.

Die Kühlvorrichtung kann ortsfest oder axial hebbar gelagert sein. Letzteres ist beispielsweise von Vorteil, wenn zu Beginn der Einkristallherstellung das im Tiegel bereitliegende Halbleitermaterial geschmolzen werden muß und die für diesen Vorgang nicht benötigte Kühlvorrichtung kurzfristig aus der Aufheizzone entfernt werden kann.

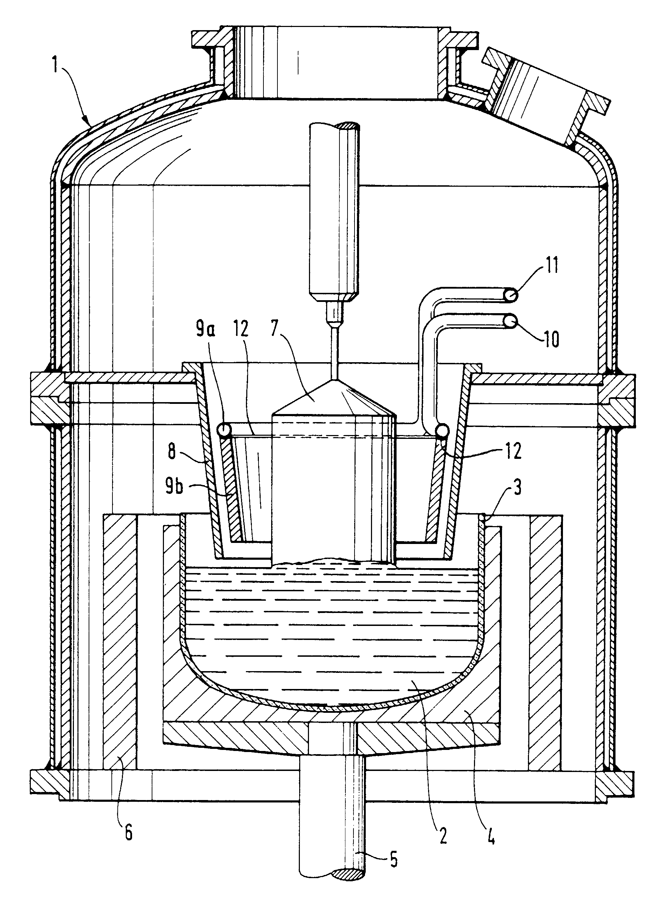

Die Erfindung wird nachfolgend an Hand der Figur näher erläutert. Sie zeigt eine bevorzugte Ausführungsform der Erfindung im Längsschnitt. Es sind nur die zum Verständnis der Erfindung wesentlichen Vorrichtungsmerkmale dargestellt.

Die Figur zeigt einen mit Inertgas spülbaren Rezipienten 1, der einen mit schmelzflüssigem Halbleitermaterial 2 gefüllten Tiegel 3 beherbergt. Der Tiegel 3 und ihn stützende Elemente 4 werden von einer drehbaren und axial beweglichen Welle 5 getragen. Seitlich des Tiegels 3 befinden sich Heizelemente 6, die zum Schmelzen des Halbleitermaterials eingesetzt werden. Der stabförmige Einkristall 7, der aus der Schmelze 2 gezogen wird, ist von einem Hitzeschild 8 umgeben. Der Hitzeschild 8 besteht aus einem Rohr, das koaxial zum Einkristall angeordnet ist und bis nahe an die Oberfläche der Schmelze heranreicht. Bevorzugt ist, daß der Durchmesser des Hitzeschilds in Schmelzenrichtung abnimmt und der Hitzeschild beispielsweise eine konusförmige Gestalt aufweist. Erfindungsgemäß ist eine zweiteilige Kühlvorrichtung 9a,b zur Kühlung des Einkristalls vorgesehen. Den oberen Teil der Kühlvorrichtung bildet das Kanalsystem 9a, das von einem flüssigen Kühlmittel durchströmt wird. Das Kühlmittel tritt durch den Zulauf 10 in das Kanalsystem 9a ein und verläßt es wieder durch den Rücklauf 11. In der Figur ist das Kanalsystem als ein den Einkristall ringförmig umgebendes Kühlrohr dargestellt. Der Abstand des Kühlrohrs 9a von der Oberfläche der Schmelze ist groß genug gewählt, daß das Kühlrohr selbst dann oberhalb der Schmelze verbleibt, wenn der Tiegel mit schmelzflüssigem Halbleitermaterial voll gefüllt und maximal angehoben ist. Der Kühlkörper 9b ist aus einem hitzebeständigen, gut wärmeleitenden Feststoff gefertigt. Er bildet den unteren, bis nahe an die Oberfläche der Schmelze weisenden Teil der Kühlvorrichtung. Der Kühlkörper 9b ist wie der Hitzeschild als Rohr ausgebildet, koaxial zum Einkristall angeordnet und weist bevorzugt einen in Schmelzenrichtung verjüngten Durchmesser auf. Das Kanalsystem 9a und der Kühlkörper 9b haben einen flächenhaften Kontakt zueinander und sind durch Befestigungsmittel 12 verbunden.

Da es durch die Erfindung ausgeschlossen ist, daß ein Kanal, durch den flüssiges Kühlmittel fließt, mit der Schmelze in Berührung kommt und Kühlmittel austritt, kann auf aufwendige sicherheitstechnische Vorrichtungsmerkmale verzichtet werden, die vorgesehen werden müßten, um auf eine derartige Störung vorbereitet zu sein. Darüber hinaus gewährleistet die Erfindung eine ebenso effektive Kühlung des wachsenden Einkristalls wie bekannte, aber ein hohes Betriebsrisiko bergende Lösungen.

## Patentansprüche

1. Vorrichtung zur Herstellung eines Einkristalls aus Halbleitermaterial nach der Czochralski-Methode, mit einem mit einer Schmelze des Halbleitermaterials gefüllten Tiegel, der auf einer axial heb- und senkbaren Welle ruht und während des Ziehens des an einer Kristallisationsfront wachsenden Einkristalls angehoben wird, und mit mindestens einem, den wachsenden Einkristall abschirmenden Hitzeschild und einer, den wachsenden Einkristall kühlenden Kühlvorrichtung, die über dem Tiegel angeordnet sind, wobei die Kühlvorrichtung zweiteilig ausgeführt ist, und ein erster, oberer Teil ein Kanalsystem umfaßt, durch das ein flüssiges Kühlmittel strömt, und ein zweiter, unterer Teil als gut wärmeleitender Kühlkörper ausgebildet ist, und wobei die Vorrichtung so konstruiert ist, daß in Betrieb nur der untere Teil der Kühlvorrichtung in die Schmelze eintaucht und der obere Teil der Kühlvorrichtung die Schmelze nicht berührt, falls der Tiegel bei maximalem Füllstand auf eine maximal erreichbare Höhe axial angehoben ist.

2. Vorrichtung nach Anspruch 1, dadurch gekennzeichnet, daß der untere Teil der Kühlvorrichtung am oberen Teil durch eine temperaturabhängig lösbare Befestigung befestigt ist.

3. Vorrichtung nach Anspruch 2, dadurch gekennzeichnet, daß der untere Teil der Kühlvorrichtung am oberen Teil mit einer niedrig schmelzenden Lotverbindung befestigt ist.

4. Vorrichtung nach einem der Ansprüche 1 bis 3, dadurch gekennzeichnet, daß der untere Teil der Kühlvorrichtung ein aus Silber gefertigter Kühlkörper oder ein mit Silber beschichteter Kühlkörper ist.

5. Vorrichtung nach Anspruch 4, dadurch gekennzeichnet, daß die zum Einkristall gerichtete Innenseite des Kühlkörpers eine Wärmestrahlung absorbierende und die ihr gegenüberliegende Außenseite eine Wärmestrahlung reflektierende Oberfläche aufweist.

## Claims

1. Apparatus for producing a single crystal of semiconductor material in accordance with the Czochralski method, comprising a crucible which is filled with a melt of the semiconductor material, rests on an axially raisable and lowerable shaft and is raised while the single crystal growing on a crystallization front is being pulled, and comprising at least one heat shield which shields the growing single crystal, and a cooling means which cools the growing single crystal, which are arranged above the crucible, the cooling means being constructed in two parts, and a first, upper part comprising a duct system through which a liquid coolant flows, and a second, lower part being designed as a cooling body having high thermal conductivity, and the apparatus being designed in such a way that, during operation, only the lower part of the cooling means is immersed in the melt and the upper part of the cooling means does not touch the melt if the crucible, with the maximum filling level, is raised axially to the maximum height which can be achieved.

2. Apparatus according to Claim 1, characterized in that the lower part of the cooling means is fastened to the upper part by a fastening which is releasable as a function of the temperature.

3. Apparatus according to Claim 1, characterized in that the lower part of the cooling device is fastened to the upper part with a low-melting solder joint.

4. Apparatus according to any one of Claims 1 to 3, characterized in that the lower part of the cooling apparatus is a cooling body made of silver or a cooling body coated with silver.

5. Apparatus according to Claim 4, characterized in that the cooling body's inside, which faces the single crystal, has a heat radiation-absorbing surface and the outside situated opposite the said inside has a heat radiation-reflecting surface.

## Revendications

1. Dispositif pour la fabrication d'un monocristal de matériau semi-conducteur selon la méthode de Czochralski, comprenant un creuset rempli d'une masse fondue du matériau semi-conducteur, qui repose sur un axe pouvant être levé et abaissé axialement, et qui est soulevé pendant l'étirage du monocristal croissant sur un front de cristallisation, et au moins un écran thermique protégeant le monocristal en croissance, ainsi qu'un dispositif de refroidissement refroidissant le monocristal en croissance, qui sont disposés au-dessus du creuset, le dispositif de refroidissement étant conçu en deux parties ; une première partie, supérieure, comprenant un système de canal dans lequel s'écoule un agent de refroidissement liquide, et une deuxième partie, inférieure, étant conçue en tant qu'élément de refroidissement conduisant bien la chaleur, le dispositif étant construit de telle façon qu'en service, seule la partie inférieure du dispositif de refroidissement plonge dans la masse fondue et que la partie supérieure du dispositif de refroidissement ne touche pas la masse fondue, au cas où le creuset, rempli au maximum, est soulevé axialement à une hauteur maximale pouvant être atteinte.

2. Dispositif selon la revendication 1, caractérisé en ce que la partie inférieure du dispositif de refroidissement est fixée à la partie supérieure par une fixation détachable dépendant de la température.

3. Dispositif selon la revendication 2, caractérisé en ce que la partie inférieure du dispositif de refroidissement est fixée à la partie supérieure au moyen d'une soudure à faible température de fusion.

4. Dispositif selon l'une des revendications 1 à 3, caractérisé en ce que la partie inférieure du dispositif de refroidissement est un élément de refroidissement fabriqué en argent ou un élément de refroidissement revêtu d'argent.

5. Dispositif selon la revendication 4, caractérisé en ce que la face intérieure de l'élément de refroidissement dirigée vers le monocristal comporte une surface absorbant le rayonnement thermique et en ce que la face extérieure opposée comporte une surface réfléchissant le rayonnement thermique.
